# EUROPEAN PATENT APPLICATION

(11) **EP 1 119 033 A1**
(43) Date of publication of application: **25.07.2001**
(21) Application number: 99943392.3
(22) Date of filing: 17.09.1999
(51) Int. Cl.: H01L 21/31, H01L 21/316, H01L 21/318

(54) **PLASMA PROCESSING METHOD**

(30) Priority: 18.09.1998 JP 28347298
(71) Applicant: TOKYO ELECTRON LIMITED, Minato-ku, Tokyo 107-8481 (JP)
(72) Inventor: ISHII, Nobuo, Minoo-shi, Osaka 562-0025 (JP); FUKIAGE, Noriaki, Tama-shi, Tokyo 206-0013 (JP); AKAHORI, Takashi, Haachioji-shi, Tokyo 192-0362 (JP)
(74) Representative: Liesegang, Eva
(86) International application number: JP9905081
(87) International publication number: WO0017920

(57) **Abstract**

A gas supply part (51) is provided in a vacuum vessel (2) so as to surround a region facing a wafer (10) so that a process gas is jetted out from the gas supply part (51) toward the wafer (10). Plasma producing microwaves are turned on and off at a frequency of 30 Hz to 500 Hz to be intermittently supplied from a radio-frequency power generating part (6) into the vacuum vessel (2). Thus, the gas remaining on the wafer (10) is replaced with a new process gas while the microwaves are turned on. Thus, the difference in degree of dissociation between the central portion and peripheral portion of the wafer (10) is not so great to uniformly carry out a plasma process.

## Description

### TECHNICAL FIELD

The present invention relates to a plasma processing method for processing substrates to be processed, such as semiconductor wafer with a plasma produced by, e.g., the electron cyclotron resonance.

### BACKGROUND ART

Recently, as a technique for carrying out deposition and etching with plasma, the ECR (Electron Cyclotron Resonance) plasma processing method is widely noticed. According to this method, high density plasma can be produced in a high vacuum with electrodeless discharge by causing microwave discharge using the resonance phenomenon between the electron cyclotron motion and microwaves (alternating current field) in a magnetic field. Therefore, there are advantages in that it is possible to realize a rapid surface treatment and that a semiconductor wafer or the like (which will be hereinafter referred to as "wafer") is not contaminated.

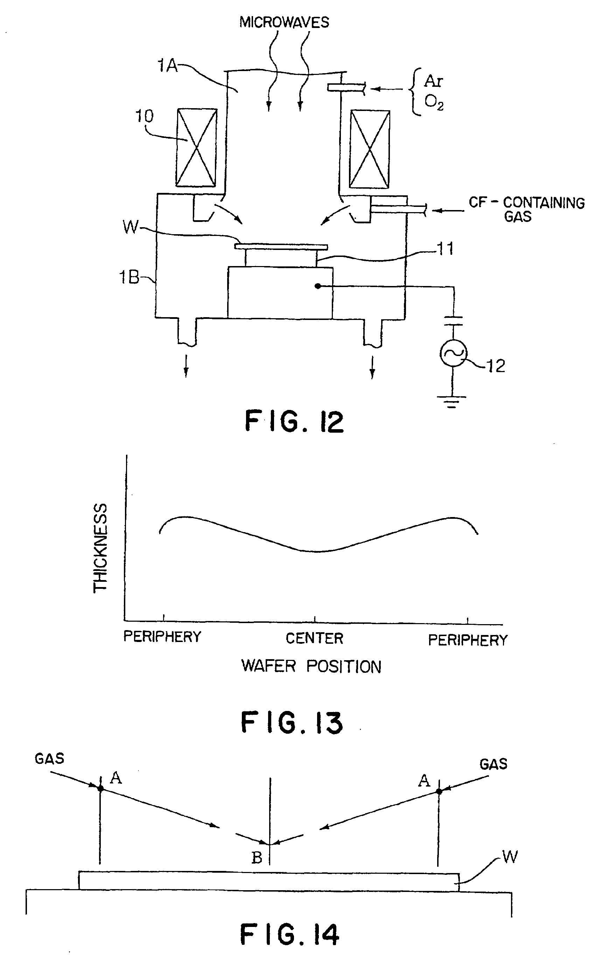

Referring to FIG. 12, a deposition process as an example of a conventional plasma processing method using the ECR plasma will be described. In a plasma processing system shown in FIG. 12, microwaves of, e.g., 2.45 GHz, are supplied into a plasma producing chamber 1A via a waveguide (not shown). Simultaneously, a magnetic field of a predetermined magnitude, e.g., 875 gausses, is applied by an electromagnetic coil 10. By the interaction (resonance) between the microwaves and the magnetic field, the high density plasma of plasma producing gasses, e.g., Ar and O₂ gases, is produced. With this plasma, a reactive gas introduced into a deposition chamber 1B is activated to form active species (radicals and so forth).

In the deposition chamber 1B, a supporting table 11 connected to a radio-frequency power supply 12 is provided, and a wafer W is supported on the supporting table 11. With the above described active species, sputter-etching and deposition are simultaneously carried out on the surface of the wafer W. The sputter-etching and deposition operations conflicting with each other are macroscopically controlled so that the deposition operation is superior to the sputter-etching operation, and a thin-film is deposited on the surface of the wafer W as a whole.

While the scale down and accelerating of semiconductor devices have been requested, CF films (fluorine-containing carbon films) have been widely noticed as effective insulating films having a small relative dielectric constant. When a CF film is deposited on the surface of a wafer, a CF-containing gas, such as C₄F₈ gas, is used as a reactive gas.

However, in the conventional plasma processing method using the processing system shown in FIG. 12, there is a problem in that the obtained CF film is thicker at the peripheral portion of the wafer and thinner at the central portion as shown in FIG. 13. This problem is more conspicuous as the diameter of the wafer increases.

Although the cause of the thickness distribution shown in FIG. 13 has not been clear, the inventors guess that the cause is as follows. That is, since the CF-containing gas is supplied from the upper outside toward the center in the deposition chamber 1B as shown in FIG. 14, the dissociation of the CF-containing gas proceeds as the CF-containing gas approaches the center of the wafer in plasma. For that reason, for example, the amount of F (fluorine) at point B is larger than that at point A. This is more conspicuous as the diameter of the wafer increases to widen a region in which plasma exists.

Fluorine produced by the dissociation of the gas serves to etch the CF film deposited on the surface of the wafer. For that reason, the etching action at the central portion containing a larger amount of fluorine component than that of the edge portion is stronger than the etching action at the edge portion. The amount of the original component of the CF-containing gas participating in deposition also decreases due to the proceeding of the dissociation of the gas as approaching the center of the wafer. Due to these causes, the CF film is thinner at the central portion of the wafer.

### DISCLOSURE OF THE INVENTION

The present invention has been made in the above described circumstances, and it is an object of the present invention to provide a plasma processing method capable of uniformly carrying out a plasma process, such as a deposition process, on the surface of a substrate to be processed, such as a wafer.

In order to accomplish this object, according to the present invention, there is provided a plasma processing method comprising the steps of: mounting a substrate to be processed on a supporting portion in a vacuum vessel; supplying a process gas to the substrate from a gas supply part to produce the plasma of the process gas with at least an electric field; and processing the substrate with the produced plasma, wherein the electric field is repeatedly turned on and off while the process gas is supplied from the gas supply part.

According to such a plasma processing method, the process gas on the substrate to be processed is replaced with a new process gas while the electric field is off. By intermittently repeating this, it is possible to uniformly process the surface of the substrate with the plasma.

In this plasma processing method, a period of time, in which the electric field is off, is preferably set to be a time required for the process gas jetted out from the gas supply part to cover the surface of the substrate to be processed. Thus, the new process gas can surely spread all over the surface of the substrate while the electric field is off, so that it is possible to more uniformly process the surface of the substrate with the plasma.

According to the present invention, there is also provided a plasma processing method comprising the steps of: mounting a substrate to be processed, on a supporting portion in a vacuum vessel; supplying a process gas from a gas supply part facing the substrate; causing an electron cyclotron resonance by an interaction between an electric field based on microwaves, which are introduced into the vacuum vessel, and a magnetic field to produce a plasma of the process gas; and processing the substrate with the produced plasma, wherein the microwaves modulated with a pulse having a frequency of 30 Hz to 500 Hz are introduced into the vacuum vessel.

According to such a plasma processing method, the microwaves modulated with the pulse are repeatedly turned on and off at the frequency of 30 Hz to 500 Hz. Thus, in the plasma process utilizing the electron cyclotron resonance, the process gas on the substrate is replaced with a new process gas while the microwaves are off, so that it is possible to uniformly process the surface of the substrate with the plasma.

The above described plasma processing method is suitable for a case where a gas of a compound containing carbon and fluorine is used as the process gas for depositing a fluorine-containing carbon film on the substrate.

In the above described plasma processing method, by applying a bias voltage, which is turned on and off in synchronism with the electric field, to the supporting portion, it is possible to prevent abnormal discharge when the bias voltage is applied.

### BRIEF DESCRIPTION OF THE DRAWINGS

FIG. 1 is a schematic diagram of an example of a plasma processing system for use in a preferred embodiment of a plasma processing method according to the present invention;

FIG. 2 is a chart showing an output waveform of a microwave in the preferred embodiment of a plasma processing method according to the present invention;

FIG. 3a is a schematic diagram for explaining a state in the system shown in FIG. 1 when a microwave is supplied (ON);

FIG. 3b is a schematic diagram for explaining a state in the system shown in FIG. 1 when the supply of a microwave is stopped (OFF);

FIG. 4 is a table showing the results in experimental example 1;

FIG. 5 is a graph showing the results in the case of condition (1) in experimental example 2;

FIG. 6 is a graph showing the results in the case of condition (2) in experimental example 2;

FIG. 7 is a graph showing the results in the case of condition (3) in experimental example 2;

FIG. 8 is a schematic diagram showing the construction of a typical ICP type plasma processing system to which the present invention can be applied;

FIG. 9 is a schematic diagram showing the construction of a typical helicon wave plasma processing system to which the present invention can be applied;

FIG. 10 is a schematic diagram showing the construction of a typical magnetron plasma processing system to which the present invention can be applied;

FIG. 11 is a schematic diagram showing the construction of a typical parallel-plate plasma processing system to which the present invention can be applied;

FIG. 12 is a schematic diagram showing a deposition system for use in a conventional plasma processing method;

FIG. 13 is a graph showing a thickness distribution of a CF film formed by a conventional plasma processing method; and

FIG. 14 is a schematic diagram for explaining a mechanism for producing the thickness distribution of FIG. 13.

### BEST MODE FOR CARRYING OUT THE INVENTION

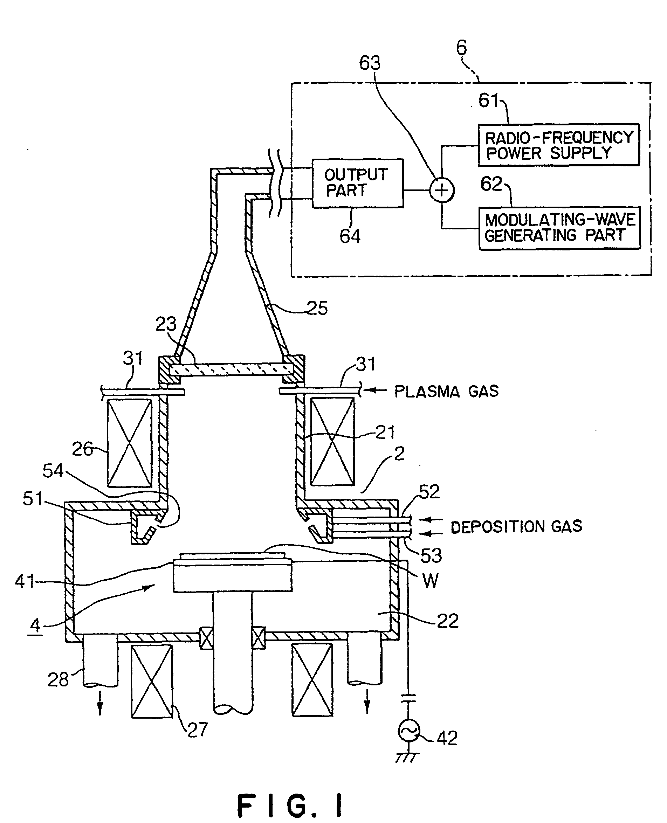

FIG. 1 is a schematic diagram showing an ECR plasma deposition system as an example of a plasma processing system for use in a preferred embodiment of a plasma processing method according to the present invention. In the system shown in FIG. 1, a wafer W serving as a substrate to be processed is mounted on a supporting table 4 in a vacuum vessel 2, and a reactive deposition gas is supplied to the wafer W from a gas supply part 51 which is arranged above the periphery of the wafer W. Microwaves are intermittently supplied to the wafer W from top in a predetermined cycle.

The vacuum vessel 2 is made of, e.g., aluminum, and grounded to have zero potential. The vacuum vessel 2 comprises a first cylindrical vacuum chamber 21, arranged in the upper portion thereof, for producing plasma, and a second cylindrical vacuum chamber 22 which is communicated with the bottom of the first vacuum chamber 21 and which has a greater diameter than that of the first vacuum chamber 21.

The top end of the first vacuum chamber 21 of the vacuum vessel 2 is open. A transmission window 23 of a microwave transmittable material, e.g., quartz, is airtightly provided in the open top end so as to hold vacuum in the vacuum vessel 2. Outside of the transmission window 23, a waveguide 25 is provided. The waveguide 25 is connected to a radio-frequency power generating part 6 for intermittently producing pulse microwaves of, e.g., 2.45 GHz. The waveguide 25 is designed to guide microwaves, which have been produced by the radio-frequency power generating part 6, in, e.g., a TE-mode, or to convert microwaves, which have been guided in TE-mode, into TM-mode, to introduce the guided or converted microwaves from the transmission window 23 into the first vacuum chamber 21.

In the vicinity of the upper end portion of the first vacuum chamber 21, i.e., directly below the transmission window 23, a plurality of gas nozzles 31 for supplying a plasma producing gas (e.g., Ar gas) into the first vacuum chamber 21 are provided. The gas nozzles 31 pass through the side wall, which defines the first vacuum chamber 21, to be connected to a gas source (not shown), e.g., an Ar gas source.

In the second vacuum chamber 22, a wafer supporting table 4 is provided so as to face the first vacuum chamber 21. An electrostatic chuck 41 having electrodes (not shown) is provided on the surface of the supporting table 4. The electrodes of the electrostatic chuck 41 are connected to a radio-frequency power supply 42 so as to apply a bias voltage for drawing ions into the wafer W, and to a DC power supply (not shown) for electrostatically holding the wafer W.

On the other hand, in the upper portion of the second vacuum chamber 22, i.e., in a portion of the second vacuum chamber 22 communicated with the first vacuum chamber 21, a ring-shaped deposition gas supply part 51 is provided. To the deposition gas supply part 51, e.g. two kinds of deposition gases are supplied from gas supply pipes 52 and 53. The deposition gas supply part 51 is designed to supply the mixture of the deposition gases to the vacuum vessel 2 from gas holes which are formed in the inner peripheral surface.

In the vicinity of the outer periphery of the side wall defining the first vacuum chamber 21, a ring-shaped main electromagnetic coil 26 serving as a magnetic field forming means is arranged. Below the second vacuum chamber 22, a ring-shaped auxiliary electromagnetic coil 27 is arranged. To the bottom of the second vacuum chamber 22, exhaust pipes 28 are connected at, e.g., two places which are symmetrical with respect to the central axis of the vacuum chamber 22.

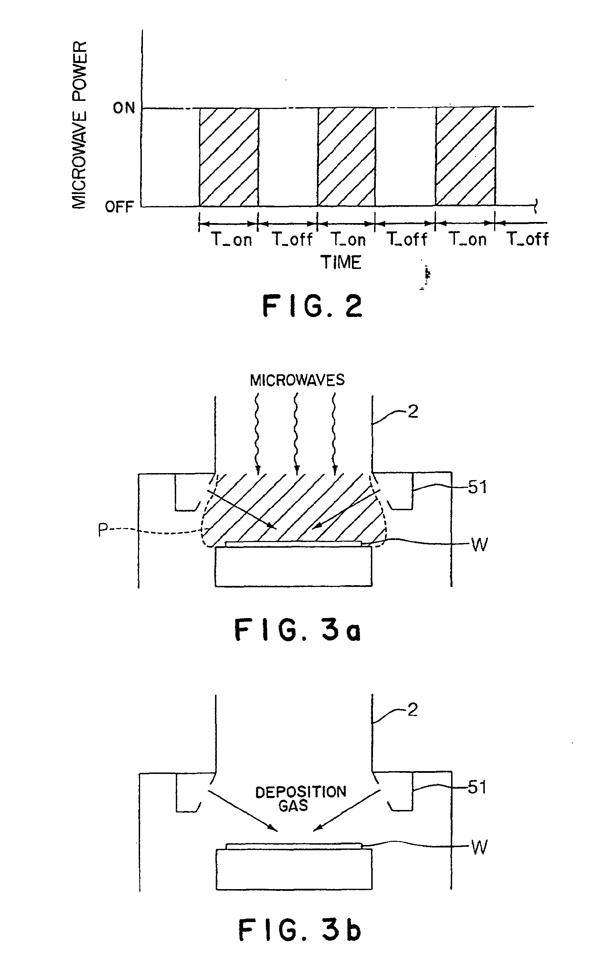

The radio-frequency power generating part 6 comprises a radio-frequency power supply 61, a modulating-wave producing part 62, a modulating part 63 and an output part 64. The radio-frequency power supply 61 is designed to produce continuous microwaves of, e.g., 2.45 GHz. The modulating-wave producing part 62 is designed to produce modulating-waves of a predetermined frequency (e.g., 50 Hz) and a predetermined duty ratio (e.g., 1). The modulating part 63 is designed to modulate microwaves, which have been produced by the radio-frequency power supply 61, with the modulating-waves, which have been produced by the modulating-wave producing part 62, to produce pulse microwaves shown in FIG. 2. The output part 64 is designed to output the pulse microwaves, which have been produced by the modulating part 63, to the waveguide 25.

Mainly referring to FIG. 1, a method for forming an interlayer dielectric film (a thin-film) of, e.g., a CF film, on a wafer W serving as a substrate to be processed, on which, e.g., an aluminum wiring, has been formed, by means of the processing system with the above described construction will be described below.

First, a gate value (not shown) provided in the side wall of the vacuum vessel 2 is open, and the wafer W is introduced from a load-lock chamber (not shown) by means of a transport arm (not shown) to be mounted on the supporting table 4.

Then, microwaves, bias voltages, electrostatic-holding voltages and gases are supplied to produce plasma to carry out a deposition process on the wafer W. Specifically, a DC voltage is applied between the electrodes of the electrostatic chuck 41 of the supporting table 4 to cause the electrostatic chuck 41 to electrostatically hold the wafer W. Subsequently, after the gate value is closed to seal the interior of the vacuum vessel 2, the internal atmosphere is exhausted by the exhaust pipes 28 to evacuate the interior of the vacuum vessel 2 to a predetermined degree of vacuum. Then, a plasma producing gas, e.g., Ar gas, is introduced from the gas nozzles 31 into the first vacuum chamber 21 at a predetermined flow rate. Deposition gases, which contain CF-containing gases, e.g., C₄F₈ gas and C₂H₄ gas, are also introduced from the deposition gas supply part 51 into the second vacuum chamber 22 at predetermined flow rates. Then, the atmosphere of the vacuum vessel 2 is held at a predetermined process pressure. The surface temperature of the supporting table 4 is set to be about 400°C.

Microwaves having an output of 2.0 kW and a frequency of 2.45 GHz are outputted from (the output part 64 of) the radio-frequency power generating part 6. The microwaves have a waveform shown in FIG. 2, wherein both of an ON-time (a period of time in which a microwave power is in an ON-state) T_on and an OFF-time (a period of time in which the microwave power is in an OFF-state) T_off are 10 ms (milliseconds). That is, in this case, the microwaves have a pulse waveform having a frequency (1 / (T_on + T_off)) of 50 Hz and a duty ratio (T_on : T_off) of 1.

The pulse microwaves pass through the waveguide 25 to reach the ceiling of the vacuum vessel 2, and pass through the transmission window 23 to be introduced into the first vacuum chamber 21. On the other hand, by the electromagnetic coil 26 and 27, a magnetic field extending from the upper portion of the first vacuum chamber 21 toward the lower portion of the second vacuum chamber 22 is formed in the vacuum vessel 2. In this case, the intensity of the magnetic field is, e.g., 875 gausses, in the vicinity of the lower portion of the first vacuum chamber 21. Thus, the electron cyclotron resonance is caused by the interaction between the electric field based on the pulse microwaves and the magnetic field, to produce and enrich the plasma of Ar gas.

The plasma flowing from the first vacuum chamber 21 into the second vacuum chamber 22 activates the CF-containing gas, which has been supplied herein, to form active species. At this time, a radio-frequency bias voltage of, e.g., 13.56 MHz and 1.5 kW, is applied to the supporting table 4 by means of the radio-frequency power supply 42. By this bias voltage, ions are attracted by the wafer W to react with the active species and so forth to deposit a CF film on the wafer W. In this case, the bias voltage applied by the radio-frequency power supply 42 is turned on and off in synchronism with the pulse microwaves in order to prevent abnormal discharge.

Thereafter, in order to actually produce a semiconductor device, the CF film on the wafer W is etched so as to have a predetermined pattern to form a groove which is filled with, e.g., a tungsten film to form a tungsten wiring.

The relationship between the pulse microwaves and the plasma flow in the above described plasma process will be described below.

As shown in FIG. 3a, since the electric field caused by the pulse microwaves is supplied during the ON-time of the pulse microwaves, the plasma producing gas is activated to form a plasma flow P. In this case, the deposition gas is supplied from the deposition gas supply part 51 to the wafer W during the OFF-time immediately before the ON-time. Then, the deposition gas is activated by the plasma flow P to form active species to deposit a thin-film on the wafer W. By this deposition, the deposition gas on the wafer W is consumed, so that the original components of the deposition gas do not sufficiently exist on the wafer W.

On the other hand, as shown in FIG. 3b, since the electric field caused by the pulse microwaves is not supplied during the OFF-time of the pulse microwaves, the plasma flow is not produced. Therefore, a new deposition gas is supplied from the deposition gas supply part 51 to the wafer W during the OFF-time, so that the original components of the deposition gas sufficiently exist on the wafer W. That is, the residual gas on the wafer W after reaction is replaced with the new deposition gas during the OFF-time, and the deposition gas is dissociated by the plasma to deposit a thin-film again during the next ON-time. Thus, the microwaves (electric field) introduced into the vacuum vessel 2 are repeatedly turned on and off using the pulse microwaves, so that the deposition process proceeds.

When a deposition process is carried out with respect to a wafer having a diameter of, e.g., 8 inches, using a CF-containing deposition gas, an example of process conditions is as follows. That is, if the pressure in the vacuum vessel 21 is 0.03 Pa, the flow rate of the CF-containing gas (e.g., C₆F₆) is 40 sccm and its flow velocity is 20 m/s, then, the frequency of the modulating-wave is preferably 50 Hz and its duty ratio is preferably 1. In this case, both of the ON-time T_on and OFF-time T_off of the pulse microwaves outputted from the radio-frequency power generating part 6 are 10 ms.

The reason for this is based on the results of the inventor's simulation using a computer. That is, when the deposition gas is jetted out from the gas holes 54 of the deposition gas supply part 51, the deposition gas has a high flow velocity of hundreds m/s, whereas the gas jetted into the second vacuum chamber 22 is immediately expanded to decelerate. The average flow velocity of the gas in the second vacuum chamber 22 is about a few m/s at a pressure of 0.01 Pa to 1 Pa in the vacuum chamber, and 10 m/s at the most. Therefore, the fact that the above described OFF-time T_off of the pulse microwaves is 10 ms is substantially coincident with the time required for the gas on the wafer W to be replaced, i.e., the time required for the deposition gas jetted out from the deposition gas supply part 51 to (sufficiently uniformly) cover the surface of the wafer W.

If the ON-time T_on is too long, the new deposition gas is supplied to the peripheral portion of the wafer while the original components of the deposition gas does not sufficiently exist on the wafer W similar to the conventional case. Therefore, the deposition proceeds while the difference in degree of dissociation of the gas between the central portion and peripheral portion of the wafer is great, so that the thickness distribution in the plane of the wafer is uneven. On the other hand, in this preferred embodiment, since the ON-time T_on of the pulse microwaves is set to be a relatively short period of time which is equal to the OFF-time T_off (the gas replacing time), the difference in degree of dissociation of the gas between the central portion and peripheral portion of the wafer W is not so great, so that the inplane uniformity of the film-thickness is improved.

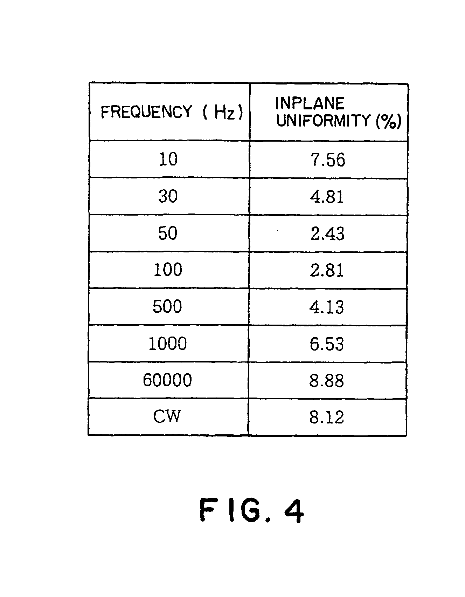

Both of the ON-time T_on and OFF-time T_off of the pulse microwaves should not be limited to 10 ms which has been described above. That is, the frequency and duty ratio of the pulse microwaves should not be limited to 50 Hz and 1, respectively, which have been described above. For example, as can be seen from experimental examples which will be described later, the frequency of the pulse microwaves is preferably in the range of from 30 Hz to 500 Hz in this preferred embodiment (see FIG. 4).

It is considered that the reason for this is that when the frequency of the pulse microwaves is too low, the ON-time T_on is too long, so that the inplane uniformity of the film-thickness is bad. Even if the microwaves are not supplied, weak plasma, which does not have so great influence on the dissociation of the gas, should exist. However, if the frequency of the pulse microwaves is too low, such weak plasma disappears, so that the system is unstable. This is not desired. On the other hand, if the frequency of the pulse microwaves is too high, this is substantially the same as the fact that plasma is continuously produced while the gas is not replaced on the wafer similar to the conventional case.

### [Experimental Example 1]

An example of an experiment, which was carried out by the inventors, will be described below.

In this experiment, CF films were deposited on wafers W having a diameter of 8 inches at various frequencies of pulse microwaves in the above described preferred embodiment. Specifically, the duty ratio of modulating-waves for producing pulse microwaves was set to be 1, and the frequencies were set to be 10 Hz, 30 Hz, 50 Hz, 100 Hz, 500 Hz, 1000 Hz and 60000 Hz. Thin-films were also deposited in a CW (Continuous Wave) state in which the microwaves remains being continuously ON.

At any frequencies (including the above descried CW), other process conditions were as follows.

### Deposition System: ECR plasma processing system (Microwaves: 2.45 GHz / 2.0 kW, High-Frequency Bias Voltage:

13.56 MHz / 1.5 kW, Main Electromagnetic Coil / Auxiliary Electromagnetic Coil Current = 200 / 160 A)
Deposition Gas: C₆F₆
Plasma-Producing Gas: Ar
Gas Flow Rate: C₆F₆ / Ar = 40 / 30 sccm
Pressure in Vacuum Vessel: 0.03 Pa
Deposition Temperature: 360 °C

The inplane uniformity of the thickness of each of the CF films obtained by such an experiment was examined. The results thereof are shown in FIG. 4. It can be seen from FIG. 4 that the inplane uniformity of the thickness is good when the frequency of the modulating-waves is in the range of from 30 Hz (T_on = T_off = 16.5 ms) to 500 Hz (T_on = T_off = 1 ms), and particularly good when the frequency of the modulating-waves is in the range of from 50 Hz (T_on = T_off = 10 ms) to 100 Hz (T_on = T_off = 5 ms). It is considered that the reason for this is that the time required for the deposition gas jetted out from the deposition gas supply part 51 to cover the surface of the wafer W is about 10 ms.

As can also be seen from the results of this experiment, according to the above described preferred embodiment, the pulse microwaves are intermittently supplied at a frequency of 30 Hz to 500 Hz to form a thin-film, e.g., a CF film, which has a more uniform thickness in the plane of the wafer. That is, it is considered that the difference in degree of dissociation of the gas between the central portion and peripheral portion of the wafer W is not so great by replacing the residual gas on the wafer W with the new deposition gas during the OFF-time T_off of the microwaves. Then, it is considered that the active species produced by the dissociation of the deposition gas is uniformly supplied onto the surface of the wafer.

### [Experimental Example 2]

Another example of an experiment, which was carried out by the inventors, will be described below.

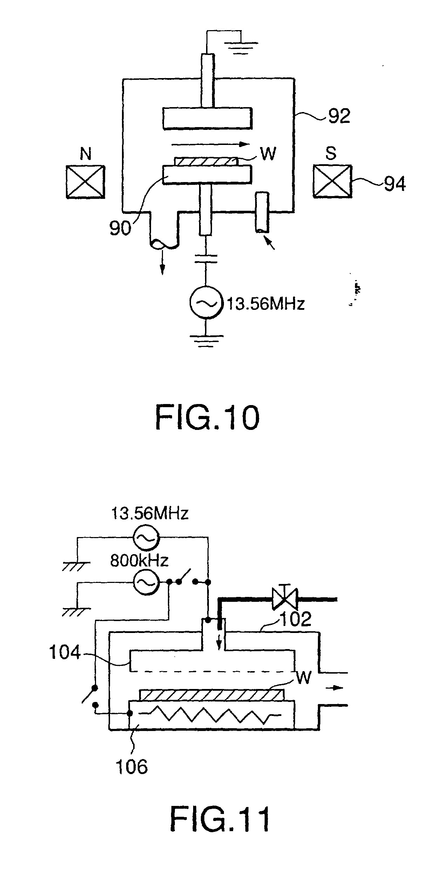

In this experiment, the frequency of pulse microwaves and the pressure in the vacuum vessel were varied under the following three conditions (1) through (3) to deposit CF films on wafers W at different frequencies and pressures to examine the variation in inplane uniformity of thickness of the films. The duty ratio of the pulse microwaves was 1.
(1) Deposition System: ECR plasma processing system
   (Microwaves: 2.45 GHz / 2.0 kW, High-Frequency Bias Voltage:
   13.56 MHz / 1.5 kW, Main Electromagnetic Coil / Auxiliary Electromagnetic Coil Current = 200 / 160 A)
   Deposition Gas: C₆F₆ (Molecular Weight 186)
   Plasma-Producing Gas: Ar
   Gas Flow Rate: C₆F₆ / Ar = 40 / 30 sccm
   Pressure in Vacuum Vessel: 0.03 Pa
   Deposition Temperature: 360 °C
(2) Deposition Gases: C₂F₆ (Molecular Weight: 138) and C₂H₄ (Molecular Weight: 28)
   Gas Flow Rate: C₂F₆ / C₂H₄ / Ar = 40 / 40 / 30 sccm
   Other conditions are the same as those in (1).
(3) Deposition System: Parallel-plate Plasma Processing System (which will be described later referring to FIG. 11)
   (Top Electrode Radio-Frequency: 13.56 MHz / 3.0 kW, Bottom Electrode Radio-Frequency: 800 kHz / 1.5 kW, Distance Between Electrodes: 20 mm)
Other conditions are the same as those in (1).

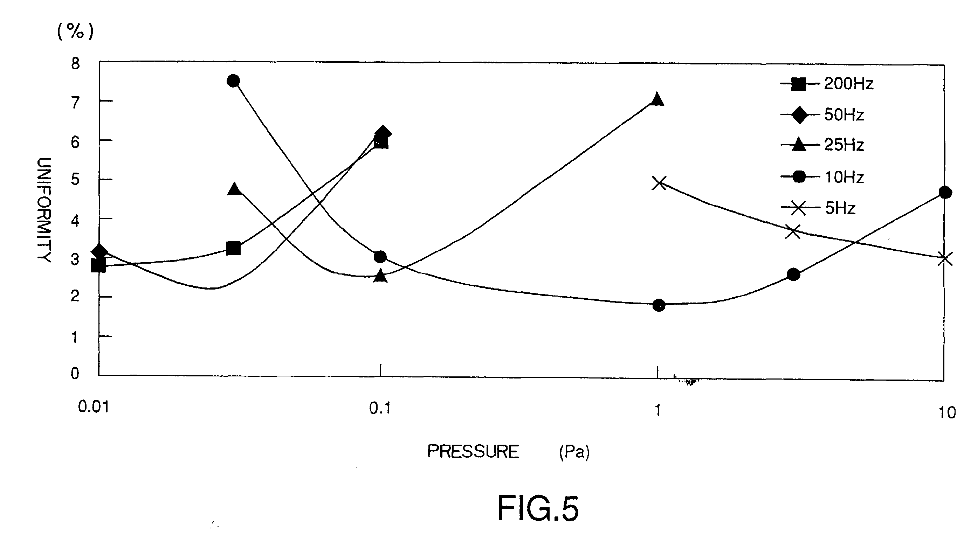

The results of experiments on the conditions (1) through (3) are shown in FIGS. 5 through 7, respectively. From these results, it can be seen that the pressure, at which the good inplane uniformity of thickness can be obtained, generally decreases as the frequency of pulse microwaves increases.

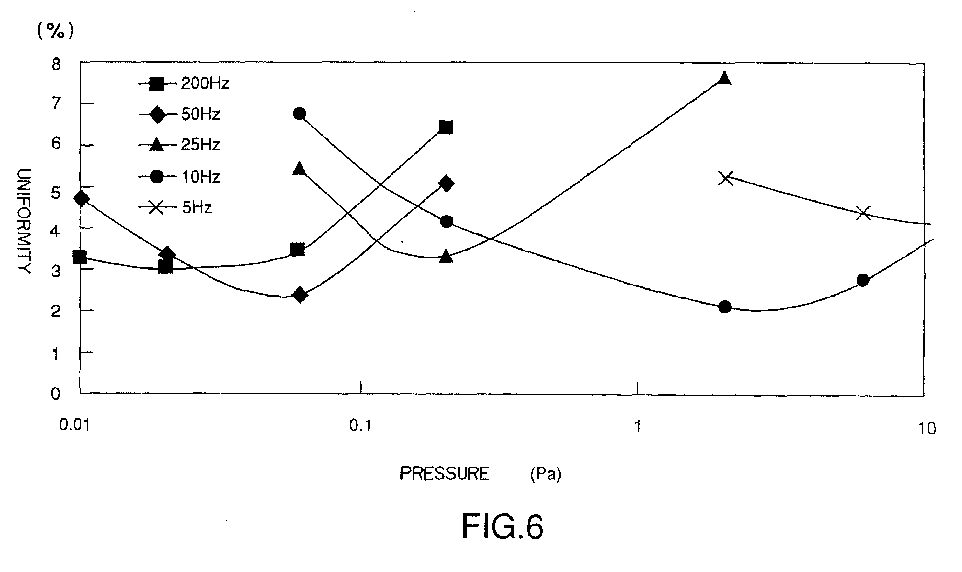

It can also be seen that on the above described conditions (2)(FIG.6), the pressure, at which the good inplane uniformity of thickness can be obtained, is higher at any frequency than that in the case of the above described conditions (1) (FIG. 5). It is considered that the reason for this is that equal flow velocities can be obtained at a higher pressure since the molecular weight of the deposition gas is small. That is, it is considered that the appropriate OFF-time, in which the good inplane uniformity of thickness can be obtained, corresponds to the time required for the deposition gas jetted out from the deposition gas supply part to cover the surface of the wafer W. This time depends on the flow velocity of the deposition gas. Therefore, the fact that equal flow velocities can be obtained at a higher pressure is that the above described appropriate OFF-time (frequency) corresponds to the higher pressure. In other words, the pressure, at which the good inplane uniformity of thickness can be obtained, increases at a certain frequency.

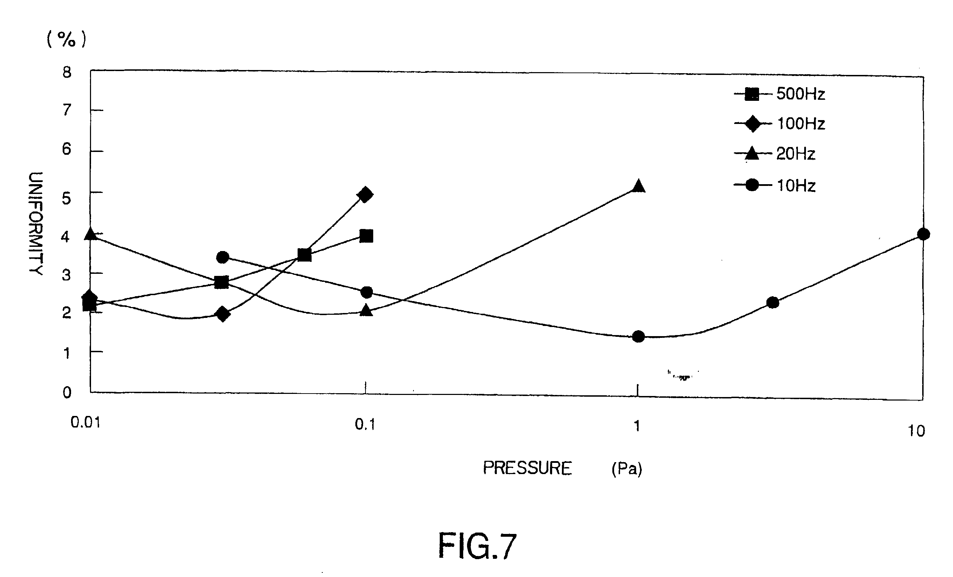

It can also be seen that the frequency, at which the good inplane uniformity of thickness can be obtained, is higher at any pressure than that in the case of the above described conditions (1) (FIG. 5) (pay attention to the fact that the frequencies serving as objects in FIG. 7 are different from those in FIGS 5 and 6). It is considered that the reason for this is that the distance between the deposition gas supply part and the wafer W in parallel-plate plasma processing systems is structurally shorter than that in ECR plasma processing systems. That is, it is considered that the time required for the deposition gas jetted out from the deposition gas supply part to cover the surface of the wafer W relatively decrease as the distance between the deposition gas supply part and the wafer W decreases, so that the appropriate OFF-time also decreases (the appropriate frequency increases).

### [Modified Examples]

The present invention should not be limited to the above described preferred embodiments. The bias voltage may be continuously applied to the supporting table 4. The deposition gas may be introduced from both of the place facing the center of the wafer and the place surrounding the wafer. The exhaust pipe may be connected via the side of the bottom of the second vacuum vessel 22. The electromagnetic coil for forming a magnetic field may be provided on the side of the waveguide 25. The application of the present invention should not be limited to deposition methods, but the invention may be applied to various processing methods for using plasma to process a substrate to be processed, e.g., a method for producing the plasma of a CF-containing gas to etch the substrate. According to the present invention, substrates to be processed should not be limited to wafers, but the substrates may be glass substrates for liquid crystal displays and so forth.

While the ON and OFF of the electric field have been repeated a plurality of times, there are some cases where the same effect can be obtained even if the electric field is turned off only once, e.g., the electric field is turned on again after the electric field is turned off for only a certain period of time, on some processing conditions.

The application of the present invention should not be limited to the production of plasma using the ECR. The invention may be applied to various plasma producing systems, as long as the systems intermittently produce plasma capable of affecting the gas dissociation. For example, ICP (Inductive Coupled Plasma), helicon-wave plasma, magnetron plasma, or parallel-plate plasma producing system may be used.

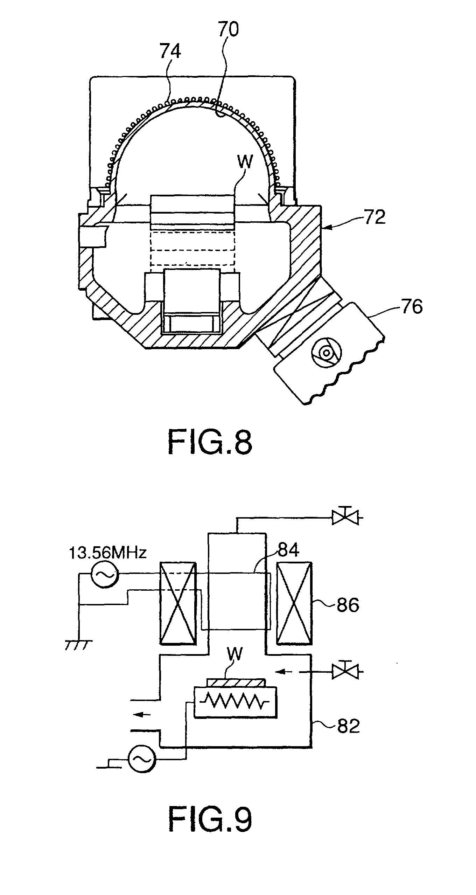

As the ICP processing system among the above described systems, a system shown in FIG. 8 is known. The IPC processing system shown in FIG. 8 has a coil 74 wound onto a dome-shaped ceramic vessel 70. This system is designed to produce plasma in a vacuum vessel 72 by electric and magnetic fields supplied from the coil 74. The vacuum vessel 72 is connected to a turbo-molecular pump 76.

As the helicon-wave plasma processing system, a system shown in FIG. 9 is known. The helicon wave plasma processing system shown in FIG. 9 has an antenna 84 for supplying helicon waves of, e.g., 13.56 MHz. This system is designed to produce plasma in a vacuum vessel 82 by the interaction between the helicon waves from the antenna 84 and the magnetic field from a magnetic coil 86.

As the magnetron plasma processing system using, a system shown in FIG. 10 is known. The magnetron plasma processing system shown in FIG. 10 is designed to produce plasma in a vacuum vessel 92 by applying a magnetic field parallel to a cathode 90 using a magnetic coil 94.

As the parallel-plate plasma processing system, a system shown in FIG. 11 is known. The parallel-plate plasma processing system shown in FIG. 11 is designed to produce plasma between a pair of parallel-plate electrodes (a top electrode 104 and a bottom electrode 106) in a vacuum vessel 102 by applying a high frequency power between the electrodes 104 and 106.

## Claims

1. A plasma processing method comprising the steps of:
mounting a substrate to be processed, on a supporting portion in a vacuum vessel;
supplying a process gas to the substrate from a gas supply part to produce the plasma of the process gas with at least an electric field; and
processing the substrate with the produced plasma,
wherein said electric field is repeatedly turned on and off while said process gas is supplied from said gas supply part.

2. A plasma processing method as set forth in claim 1, wherein a period of time in which said electric field is off is set to be a time required for said process gas jetted out from said gas supply part to cover the surface of said substrate.

3. A plasma processing method comprising the steps of:
mounting a substrate to be processed, on a supporting portion in a vacuum vessel;
supplying a process gas from a gas supply part facing the substrate;
causing an electron cyclotron resonance by an interaction between an electric field based on microwaves, which are introduced into said vacuum vessel, and a magnetic field to produce a plasma of the process; and
processing the substrate with the produced plasma,
wherein said microwaves modulated with a pulse having a frequency of 30 Hz to 500 Hz are introduced into said vacuum vessel.

4. A plasma processing method as set forth in claim 2, wherein said process gas is a gas of a compound containing carbon and fluorine, and a fluorine-containing carbon film is deposited on said substrate.

5. A plasma processing method as set forth in any one of claims 1 through 4, wherein a bias voltage, which is turned on and off in synchronism with said electric field, is applied to said supporting portion.
